# EUROPEAN PATENT APPLICATION

(11) **EP 1 688 810 A1**
(43) Date of publication of application: **09.08.2006**
(21) Application number: 04819392.4
(22) Date of filing: 25.11.2004
(51) Int. Cl.: G05B 19/418

(54) **CIRCUIT SUBSTRATE MANUFACTURING METHOD AND SYSTEM, SUBSTRATE USED FOR THE SAME, AND CIRCUIT SUBSTRATE USING THE SAME**

(30) Priority: 28.11.2003 JP 2003398401
(71) Applicant: MATSUSHITA ELECTRIC INDUSTRIAL CO., LTD., Kadoma-shi, Osaka 571-8501 (JP)
(72) Inventor: KOBAYASHI, Tokumi, x (JP)
(74) Representative: Haley, Stephen
(86) International application number: PCT/JP2004/017467
(87) International publication number: WO 2005/052705

(57) **Abstract**

A circuit substrate production method in which a substrate produced by a substrate manufacturer (1) is delivered to a subsequent mounting manufacturer (2) for mounting electronic components at the mounting manufacturer (2) to thereby produce a circuit substrate. A substrate board (5) is employed which is separated into, via substrate sheets (6), substrate pieces (7) at one or each of a plurality of separation levels. Identification information formed of information related to the entire substrate and information representing relative relationship about the separation at each of the separation levels is recorded on each of information recording portions (8, 9, 10) each of which is provided so as to correspond to each substrate before separation and after separation at each separation level, and then the substrate is delivered from the substrate manufacturer (1) to the mounting manufacturer (2). Since the history of the substrate is traced by referring to the identification information, the production progress status of a circuit substrate which is separated with production efficiency improved by use of a multi-piece substrate is easily traced, and also the production history when a failure occurs is easily traced.

## Description

### TECHNICAL FIELD

The present invention relates to a circuit substrate production method and system, and particularly to a circuit substrate production method and system in which a multi-piece substrate which is to be separated into a plurality of pieces at one or each of a plurality of separation levels is produced at a substrate manufacturer, is separated properly, and is delivered to a component-mounting manufacturer where components including electronic parts are mounted on the separated substrate to thereby produce a circuit substrate. The invention also relates to the multi-piece substrate and to the circuit substrate.

### BACKGROUND ART

Conventionally, in the production of a circuit substrate of various electronic devices, the design data of a substrate based on the design data of the circuit substrate is given to a substrate manufacturer. The substrate manufacturer produces the substrate based on the substrate design data. At this time, for the purpose of production management and delivery management, identification information specific to the substrate manufacturer is written for each lot and each individual substrate. Subsequently, the substrate is supplied to a mounting manufacturer, and component-mounting data based on the design data of the circuit substrate is given to the mounting manufacturer. In the mounting manufacturer, in order to mount required components on the substrate and perform production management, information, such as identification information of the substrate, specific to the mounting manufacturer is written on a proper blank area of the substrate. Further, at this time, the mounting is also performed with high productivity by feeding the substrate to a mounting line with information required for mounting in the mounting line also written thereon.

Further, an apparatus in a production system provided with a plurality of working stations is known in which an ID tag identifying an individual workpiece is provided for each workpiece to manage the working history for each workpiece by means of working history management means employing a computer and in which, in order to reduce the work load of the working history management means, a network is constructed which is provided with working history storage means for storing the working history for each workpiece and transmission means (see, for example, Patent Document 1).

Moreover, a system is known in which data processing means and various files, such as a set-to-substrate serial number association file in which a set serial number and the serial number of a substrate are written, a substrate-manufacturing modification communication file, and a fault history file in which fault history for each set and substrate fault history are written, are connected online, whereby manufacturing modification history and fault occurrence history can be searched for each set of a predetermined model and for each substrate (see, for example, Patent Document 2).
[Patent Document 1] Japanese Patent Publication No. 10-333740.
[Patent Document 2] Japanese Patent Publication No. 8-222887.

By the way, recently, along with the downsizing and high density mounting of electronic devices, each circuit substrate tends to be small. Thus, in a substrate manufacturer, a large size multi-piece substrate in which a plurality of substrates are arranged is produced, and the substrate is then separated and delivered to a mounting manufacturer. Similarly, also in the mounting manufacturer, electronic components are mounted on the plurality of substrates collectively to attempt to improve production efficiency. On the other hand, the production method itself becomes significantly complicated due to the production of small batches of a variety of products, the short lifecycle of products, outsourcing production, production in an oversea factory, and the like. Therefore, in the abovementioned conventional circuit substrate production method, a problem exists that it is extremely difficult to trace and search the latest production progress status or the like of any circuit substrate in real time. Further, a problem exists that, when a defective product is found, it is extremely difficult to identify the cause thereof and to take measures.

In addition, since identification information and information required for manufacturing are written for each lot and for each substrate by each manufacturer, a writing apparatus, such as a laser marker, for writing information is provided in each manufacturer. Therefore, particularly when a lot of information is written for improving production efficiency, a problem exists that the man-hour for writing and a facility cost increase.

In order to solve such problems, the production history of a product must be traceable at any time including the production time. However, a problem exists that this cannot be realized since the information written on individual products at each production site such as each manufacturer can be analyzed only at the each production site.

Further, since the means disclosed in Patent Documents 1 and 2 above are applicable only to a product produced in one production site such as each manufacturer, such problems cannot be solved.

In view of the above conventional problems, it is an object of the present invention to provide a circuit substrate production method and system capable of easily tracing the production progress status of split circuit substrates and the production history upon the occurrence of a failure with the production efficiency of the circuit substrate improved by use of a multi-piece substrate and of attempting to reduce the man-hour for recording information on the substrate to reduce a production cost.

### DISCLOSURE OF THE INVENTION

The circuit substrate production method of the present invention is a circuit substrate production method in which a substrate produced by a substrate manufacturer is delivered to a subsequent mounting manufacturer for mounting components at the mounting manufacturer to thereby produce a circuit substrate. In this method, a multi-piece substrate is employed which is to be separated into a plurality of pieces at one or each of a plurality of separation levels. In addition, in the substrate manufacturer, identification information formed of information related to the entire substrate and information representing relative relationship about the separation at each of the separation levels is recorded on each of information recording portions each of which is provided so as to correspond to each substrate before separation and after separation at each separation level, and the substrate is delivered to the mounting manufacturer. A large size multi-piece substrate is employed, and the substrate is separated and then delivered to the mounting manufacturer, thereby attempting to improve production efficiency. At the same time, even when the production method itself becomes significantly complicated due to the production of small batches of a variety of products, the short lifecycle of products, outsourcing production, production in an oversea factory, and the like, the latest production progress status and the like of any circuit substrate are easily traced and searched in real time by referring to the identification information. Further, when a defective circuit substrate is found, the cause thereof is identified, and measures are easily taken. Moreover, when the identification information in the substrate manufacture and that in the mounting manufacturer are not common with regard to the entire substrate and are different from each other, the information related to the entire substrate contains both the identification information in the substrate manufacture and the identification information in the mounting manufacture.

In terms of a mounting manufacturer, the circuit substrate production method of the present invention is a circuit substrate production method in which, at a mounting manufacturer, components are mounted on a substrate produced by a substrate manufacturer and delivered to the subsequent mounting manufacturer to thereby produce a circuit substrate. In this method, a multi-piece substrate is employed which is to be separated into a plurality of pieces at one or each of a plurality of separation levels. In addition, at the mounting manufacturer, identification information employed in the mounting manufacturer is recorded on each of information recording portions on the substrate in which, at the substrate manufacturer, identification information formed of information related to the entire substrate and information representing relative relationship about the separation at each of the separation levels has been recorded on each of the information recording portions each of which is provided so as to correspond to each substrate before separation and after separation at each separation level. As described above, even when the production method itself becomes significantly complicated due to the production of small batches of a variety of products, the short lifecycle of products, outsourcing production, production in an oversea factory, and the like, the latest production progress status of any circuit substrate is easily traced and searched in real time by referring to the identification information. Further, when a defective circuit substrate is found, the cause thereof is identified, and measures are easily taken.

Further, the circuit substrate production system of the present invention is a circuit substrate production system in which a multi-piece substrate, which is to be separated into a plurality of pieces at one or each of a plurality of separation levels and has information recording portions each of which is provided so as to correspond to each substrate before separation and after separation at each separation level, is produced at a substrate manufacturer, the substrate produced at the substrate manufacturer being delivered to a subsequent mounting manufacturer, and in which an electronic component is mounted on the substrate in the mounting manufacturer to thereby produce a circuit substrate. In the substrate manufacturer, recording means is provided which records, on each of the information recording portions of the substrate, identification information formed of information related to the entire substrate and information representing relative relationship about the separation at each of the separation levels. In the mounting manufacturer, read-out means is provided which reads information from the information recording portions. In the circuit substrate production system, the above production method is performed, and the latest production progress status and the like of any circuit substrate are easily traced and searched in real time by referring to the identification information. In addition, when a defective product is found, the cause thereof is determined, and measures are easily taken.

Moreover, the multi-piece substrate of the present invention is a multi-piece substrate which has one or a plurality of separation levels and is to be separated into a plurality of pieces at each of the separation levels. In the multi-piece substrate, information recording portions are provided, each of which corresponds to each substrate before separation and after separation at each separation level, and identification information formed of information related to the entire substrate and information representing relative relationship about the separation at each of the separation levels is recorded on each of the information recording portions. By employing this multi-piece substrate, the latest production progress status and the like of any substrate are easily traced and searched in real time by referring to the identification information. In addition, when a defective circuit substrate is found after the production, the cause thereof is identified, and measures are easily taken.

Further, the circuit substrate of the present invention is a circuit substrate which is formed by mounting a component on a substrate formed by separating a multi-piece substrate into a plurality of pieces at one or each of a plurality of separation levels. The circuit substrate has an information recording portion, and identification information formed of information common to all the substrates in the multi-piece substrate and information representing relative relationship between substrates separated at each of the separation levels is recorded on the information recording portion. When a defective circuit substrate is found, the production history of the circuit substrate is traced and searched based on the identification information. Further, the cause of the defective is identified, and measures are easily taken.

Moreover, in another circuit substrate production method of the present invention, a combination of production step information and identification information is data-processed in a data processing center to thereby construct various databases, the production step information being transmitted from a substrate manufacturer and a mounting manufacturer via a communication network and being related to each of substrates each of which is included in a multi-piece substrate separated into a plurality of pieces at one or each of a plurality of separation levels and serves as a substrate before separation and after separation at each separation level, the identification information being formed of information related to the entire substrate read out from information recording portions provided in each substrate, and information representing relative relationship about the separation at each of the separation levels. Therefore, even when the production method becomes complicated, required history information and the like of any circuit substrate are obtained readily and adequately from the databases via the communication network. Thus, it is possible to properly address the occurrence of various events such as the case in which, when a defective product is found, the cause thereof is identified to take measures and to properly address various needs such as the grasping of the production progress status of any circuit substrate and the grasping of the status of use, the status of stocks, and the like.

Further, still another circuit substrate production method of the present invention is a circuit substrate production method in which a substrate produced by a substrate manufacturer is delivered to a subsequent mounting manufacturer for mounting a component at the mounting manufacturer to thereby produce a circuit substrate. When the substrate manufacturer records identification information on an information recording portion provided on the substrate and delivers the substrate to the mounting manufacturer, information related to a production step at the substrate manufacturer and information related to a production step in the mounting manufacturer are recorded, in addition to the identification information of the substrate, on the information recording portion at the substrate manufacturer. Therefore, since the substrate manufacturer has recorded information required for a mounting step at the subsequent mounting manufacturer, the man-hour for recording information on the substrate at the mounting manufacturer is eliminated or reduced, and efficient production is achieved while the production cost is reduced.

Moreover, further another circuit substrate production method of the present invention is a circuit substrate production method in which a substrate produced by a substrate manufacturer is delivered to a subsequent mounting manufacturer for mounting a component at the mounting manufacturer to thereby produce a circuit substrate. When the substrate manufacturer records identification information on an information recording portion provided on the substrate and delivers the substrate to the mounting manufacturer, production step information about the substrate and the identification information read out from the information recording portion are combined in the substrate manufacturer and the mounting manufacturer, is transmitted to a data processing center connected via a communication network, and is data-processed at the data processing center to thereby construct various databases. The substrate manufacturer and the mounting manufacturer perform required processing by retrieving required data from the databases via the communication network. Therefore, even when the production method becomes complicated, required history information and the like of any circuit substrate are obtained readily and adequately from the databases via the communication network. Thus, it is possible to properly address the occurrence of various events such as the case in which, when a defective product is found, the cause thereof is identified for taking measures and to properly address various needs such as the grasping of the production progress status of any circuit substrate and the grasping of the status of use, the status of stocks, and the like.

Further, another circuit substrate of the present invention is a circuit substrate in which, in addition to identification information of a substrate, production records of both a substrate manufacturer and a mounting manufacturer are recorded on an information recording portion provided in the substrate. When a defective circuit substrate is found, the production history of the circuit substrate is traced and searched based on the identification information. Further, the cause of the defective is identified, and measures are easily taken.

### BRIEF DESCRIPTION OF THE DRAWINGS

Fig. 1 is a schematic block diagram of a circuit substrate production system of an embodiment of the present invention.
Fig. 2 is a schematic view for explaining a substrate board employed in the production system of the same embodiment.
Fig. 3 is a view for explaining information recorded on an information recording portion of a substrate in the same embodiment.

### BEST MODE FOR CARRYING OUT THE INVENTION

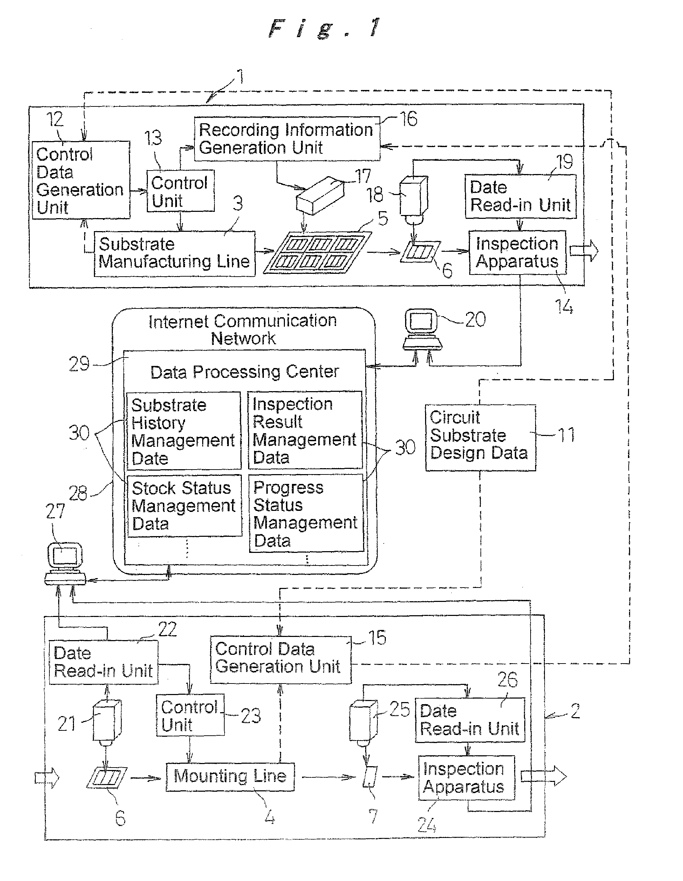

One embodiment of a circuit substrate production method and system of the present invention will next be described with reference to Figs. 1 to 3.

In this embodiment, as shown in Fig. 1, a large size multi-piece substrate (hereinafter referred to as a substrate board) 5 in which a plurality of substrates are arranged is manufactured on a substrate manufacturing line 3 of a substrate manufacturer 1, and this is separated into substrates (each hereinafter referred to as a substrate sheet) 6, in which a plurality of substrates each serving as a circuit substrate (hereinafter referred to as a substrate piece) are arranged. The substrate sheets 6 are delivered and supplied to a mounting manufacturer 2. On a mounting line 4 of the mounting manufacturer 2, required electronic components are mounted on each of substrate pieces 7 of the substrate 6, and each of the substrate pieces 7 is separated to thereby produce a circuit substrate.

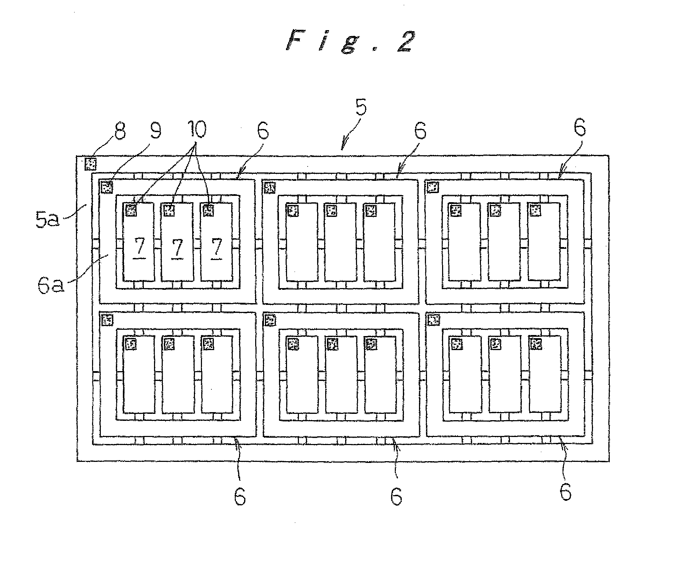

As shown in Fig. 2, the substrate board 5 is configured to have a plurality of the substrate sheets 6 mutually connected and arranged in an outer frame 5a thereof, and an information recording portion 8, on which information related to the entire substrate board 5 is recorded, is provided in an appropriate position in the outer frame 5a. The substrate sheet 6 is configured to have a plurality of the substrate pieces 7 mutually connected and arranged within an outer frame 6a thereof, and an information recording portion 9, on which the information related to the entire substrate board 5 and information representing the identification of the substrate sheet 6 in this substrate board 5 are recorded, is provided in an appropriate position in the outer frame 6a. In the substrate piece 7, an information recording portion 10, on which the information related to the entire substrate board 5 and information representing the identification of the substrate piece 7 in the substrate sheet 6 in this substrate board 5 are recorded, is provided in an appropriate position therein.

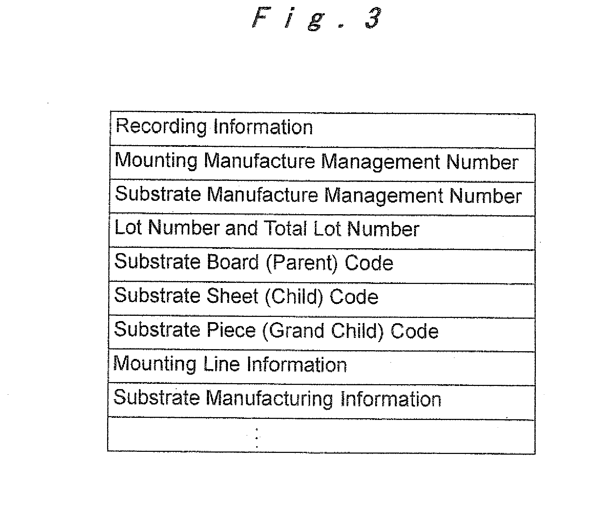

For example, as shown in Fig. 3, the information recorded in these information recording portions 8 to 10 includes: a mounting manufacturer management number and substrate manufacturer management number for a circuit substrate to be produced; a lot number in a manufacturing lot of the circuit substrate having these numbers; the total number of the substrate boards 5 included in the lot; a substrate board code (a parent code) indicating the sequence number of the substrate board 5 in the lot; a substrate sheet code (a child code) indicating the position of the substrate sheet 6 in the substrate board 5; a substrate piece code (a grandchild code) indicating the position of the substrate piece 7 in the substrate sheet 6; information in a manufacturing step on the substrate manufacturing line 3 such as a manufacturing start time, a manufacturing finish time, an operator name, and a name of employed equipment; and information required for production on the mounting line 4, such as a mounting program which is for operating a component-mounting apparatus and formed of information including a mounting component name in each component-mounting point, mounting position coordinates on the substrate, a moving speed of a placement head for mounting a component, and operation information of an employed adsorption nozzle and the like. The information is provided as, for example, a series of multi-digit alphanumeric strings.

The substrate manufacturing line 3 and the mounting line 4 are operated and controlled based on design data 11 of the circuit substrate. Therefore, within the design data 11 of the circuit substrate, design data related to the manufacturing of the substrate board 5 and the separation into the substrate sheets 6 is supplied to the substrate manufacturer 1. The design data of the substrate board 5 is input to a control data generation unit 12. By referring to the data related to the substrate manufacturing line 3, control data for manufacturing the substrate board 5 on the substrate manufacturing line 3 is generated and stored in a control unit 13, the control data including an operation program for a substrate-forming apparatus and an operation program for a drawing apparatus of a wiring pattern on the substrate. The substrate manufacturing line 3 is operated and controlled by the control unit 13 based on the control data. The substrate boards 5 are produced in sequence, then separated into each substrate sheet 6, inspected by an inspection apparatus 14, and supplied and delivered to the mounting manufacturer 2.

Within the design data 11 of the circuit substrate, mounting-design data related to electronic components mounted on each substrate piece 7 of the substrate sheet 6 is supplied to the mounting manufacturer 2. The mounting design data is input into a control data generation unit 15. By referring to the data related to the mounting line 4, control data for mounting electronic components on each substrate piece 7 of the substrate sheet 6 in the mounting line 4 is generated, the control data including a mounting program which is for operating a component-mounting apparatus and is formed of information including: a mounting component name in each component-mounting point; mounting position coordinates on the substrate; a moving speed of a placement head for mounting a component; and operation information for an employed adsorption nozzle and the like. The control data is supplied to the substrate manufacturer 1.

Here, in an example shown in Fig. 1, an exemplary case is shown in which the control data generated in the control data generation unit 15 of the mounting manufacturer 2 is supplied to the substrate manufacturer 1, but this is not restrictive. The mounting design data for the electronic components to be mounted may be supplied to the substrate manufacturer 1, and the information for the mounting line 4 may also be supplied to the substrate manufacturer 1 from the mounting manufacturer 2 to generate the control data of the mounting line 4 at the substrate manufacturer 1.

Moreover, in the substrate manufacturer 1, data is input from the control unit 13 to a recording information generation unit 16 in order to record, on each of the information recording portions 8, 9, and 10 of the substrate board 5: information for separately identifying the substrate boards 5 produced in sequence, the substrate sheets 6 thereof, and the substrate pieces 7 thereof; and manufacturing information of the substrate board 5, the substrate sheet 6, and the substrate piece 7, such as names of a substrate-forming apparatus and a wiring pattern-drawing apparatus employed when the substrate is manufactured, an operator name, a manufacturing start time, a manufacturing finish time, a part number of material constituting the substrate, and a lot number. At the same time, the control data for the substrate board 5 in the control data which is for mounting the electronic components and is supplied from the abovementioned mounting manufacturer 2 is also input to this recording information generation unit 16. The information for the substrate board 5 is converted into recording information by the recording information generation unit 16 and is output to recording means 17 such as a laser marker. The recording information is then recorded on each of the information recording portions 8, 9, and 10 provided in the substrate board 5 by means of the recording means 17. A lot of information as shown in Fig. 3 are easily recorded at low cost by writing a two-dimensional code on these information recording portions 8, 9, and 10.

After the corresponding information is recorded on each of the information recording portions 8, 9, and 10 of the substrate board 5 by means of the recording means 17, the substrate board 5 is separated into the substrate sheets 6. Subsequently, various performance inspections for each of the substrate sheets 6 are performed by means of the inspection apparatus 14. At this time, in order to associate the substrate sheet 6 with the inspection results thereof, the information recorded on the information recording portions 9 and 10 of the substrate sheet 6 and the substrate piece 7 thereof, respectively, is read out by means of read-out means 18, and the individual information of the substrate sheet 6 and the substrate piece 7 thereof is read into a data read-in unit 19. The individual information and inspection data of the substrate sheet 6 and the substrate piece 7 thereof are input to data processing-transmitting-receiving means 20 constituted by a personal computer. Subsequently, the substrate sheet 6 is supplied and delivered to the mounting manufacturer 2 as described above.

In the mounting manufacturer 2, before the substrate sheet 6 is fed to the mounting line 4, the information written on the information recording portions 9 and 10 is read out by means of read-out means 21 such as a code reader, and the control data of the mounting line 4 is read into a data read-in unit 22 and is output to a control unit 23. Thus, the mounting line 4 is operated and controlled based on the control data read by the control unit 23, and a predetermined electronic component is mounted on each of the substrate pieces 7 of the substrate sheet 6 fed to the mounting line 4, thereby producing the circuit substrate in sequence.

Here, the above method is not restrictive. A method may be employed in which the identification name of the control data (for example, a mounting program name of a component-mounting apparatus) is recorded on each of the information recording portions 8, 9, and 10 at the substrate manufacturer 1. Further, the real body of the control data (the mounting program of a component-mounting apparatus) may be stored in each component-mounting apparatus of the mounting manufacturer 2 or in the control unit 23. In this case, at the mounting manufacturer 2, the control data is read from each of the information recording portions 8, 9, and 10 by means of the read-out means 21, and the name of the control data is recognized to select the corresponding one from the control date stored in advance in each of the component-mounting apparatus or in the control unit 23.

The substrate sheet 6 which has electronic components mounted thereon and has been conveyed from the mounting line 4 is separated into the substrate pieces 7 corresponding to a circuit substrate, and then various performance inspections for each of the substrate pieces 7 are performed by means of an inspection apparatus 24. At this time, in order to associate the substrate piece 7 with the inspection results thereof, the information recorded on the information recording portion 10 of the substrate piece 7 is read out by means of read-out means 25, and the individual information of the substrate piece 7 is read by a data read-in unit 26. The individual information and inspection data of the substrate piece 7 are input to data processing-transmitting-receiving means 27 constituted by a personal computer. Further, data which is detected by the data read-in unit 22 and is for the substrate sheet 6 to be carried into the mounting line 4 is also input to this data processing-transmitting-receiving means 27.

The data processing-transmitting-receiving means 20 and 27 of the substrate manufacturer 1 and the mounting manufacturer 2, respectively, are connected to an internet communication network 28 and are connected to a data processing center 29 via the internet communication network 28. The data processing center 29 has: various databases 30 for products at production sites such as the substrate manufacturer 1 and the mounting manufacturer 2 and for the production thereat; data receiving-processing means for receiving-processing the data transmitted from each of the production sites and for storing the data in each of the databases; and searching-transmitting means for searching required information from the databases according to the requirement from each of the production sites and for transmitting the required information to each of the production sites.

Thus, the identification information of the substrate board 5, the substrate sheet 6, and the substrate piece 7, the inspection data by means of the inspection apparatus 14 and 24, and the like are input to the data processing center 29 from the data processing-transmitting-receiving means 20 and 27. In the data processing center 29, the input information is processed to construct the various databases 30, and the data processing-transmitting-receiving means 20 and 27 of each of the production sites such as the substrate manufacturer 1 and the mounting manufacturer 2 retrieve required information by freely accessing these databases 30.

Examples of the constructed database 30 include: a database of stock status in each production site (for example, information at the substrate manufacturer 1, such as the stock quantities and delivery schedules of materials constituting the substrate and wiring materials, and information in the mounting manufacturer 2, such as the stock quantity of the substrate delivered from the substrate manufacturer 1, the stock quantities of mounting components, and delivery schedules thereof); history management data of each of the substrate boards 5, substrate sheets 6, and substrate pieces 7 (for example, information in the substrate manufacturer 1, such as: names of a substrate-forming apparatus and wiring pattern drawing apparatus employed when the substrate is manufactured; an operator name; a manufacturing starting time; a manufacturing finish time; a part number of material constituting the substrate; and a lot number, and information in the mounting manufacturer 2, such as: names of a component-mounting line and component-mounting apparatus employed when components are mounted; an operator name; a manufacturing starting time; a manufacturing finish time; names, manufacturer names, and lot numbers of the mounted components; a name of an adsorption nozzle employed for mounting; and an identification number of a feeder); a progress status database for production of each substrate; an inspection result database for each substrate piece 7; a database for managing other orders; a database of energy used; and a work achievement database for each facility.

The method in which the history management data is accumulated in the databases 30 in the data processing center 29 is not restrictive. A method may be employed in which manufacturing history upon manufacturing at the substrate manufacturer 1 and manufacturing history upon manufacturing at the mounting manufacturer 2 are recorded in the information recording portions 8, 9, and 10 of the substrates 5, 6, and 7, respectively. By employing such a method, the manufacturing history at a plurality of production sites such as the substrate manufacturer 1 and the mounting manufacturer 2 involved in the manufacturing of the mounted substrate are referred to by simply reading the information recording portions 8, 9, and 10 of the substrates 5, 6, and 7, respectively. In addition, tracing for identifying the cause of a failure or the like is easily performed in a similar manner to that of referring to the databases 30 of the data processing center 29.

According to this embodiment, in the substrate manufacturer 1, a substrate is manufactured in the form of the large size substrate board 5 having a large number of the substrate pieces 7 each serving as a circuit substrate. The substrate is separated and then delivered to the mounting manufacturer 2, thereby attempting to improve production efficiency. At the same time, even when the production method itself becomes significantly complicated due to the production of small batches of a variety of products, the short lifecycle of products, outsourcing production, production in an oversea factory, and the like, the latest production progress status or the like of any circuit substrate is easily traced and searched in real time by referring to the identification information. Further, when a defective circuit substrate is found, the location of the cause thereof is identified from the identification information therefor and the information of the production step, and thus measures are easily taken.

Further, since the arbitrary referenceable databases 30 are constructed by concentrating the data in the substrate manufacturer 1 and the mounting manufacturer 2 on the data processing center 29 via the connected internet communication network 28, the management cost of data in the substrate manufacturer 1 and the mounting manufacturer 2 are reduced, and the risk management of the manufacturing data is performed. Further, the quality of the circuit board is traced, and the quality data is referred to in real time. Moreover, even when the production system is complicated, a pinpoint trace of the cause when a defective of product occurred is performed, and measures are taken rapidly and properly, and the quality of the circuit substrate are easily improved. Further, various needs such as the grasping of the production progress status of any substrate board 5, substrate sheet 6, and substrate piece 7 and the grasping of the status of use, the status of stocks, and the like are addressed appropriately.

In addition, in the above description of the embodiment, an example is shown in which the production is performed by delivering between two manufacturers, i.e., the substrate manufacturer 1 and the mounting manufacturer 2. However, it is needless to say that the applicability is extended to an arbitrary number of production sites.

### INDUSTRIAL APPLICABILITY

As described above, according to the circuit substrate production method and system of the present invention, production efficiency is attempted to be improved by separating the multi-piece substrate to deliver the separated substrates to a mounting manufacturer. At the same time, the latest production progress status and the like of any circuit substrate are easily traced and searched in real time based on the identification information recorded on each substrate by referring to the identification information even when the production method itself becomes significantly complicated due to the production of small batches of a variety of products, outsourcing production, production in an oversea company, and the like. In addition, when a defective product is found, the cause thereof is identified, and measures are easily taken. Therefore, the circuit substrate production method and system of the present invention are useful for the production of various circuit substrates.

## Claims

1. A circuit substrate production method in which a substrate produced by a substrate manufacturer (1) is delivered to a subsequent mounting manufacturer (2) for mounting a component at the mounting manufacturer to thereby produce a circuit substrate, wherein:
a multi-piece substrate (5) is employed which is to be separated into a plurality of pieces at one or each of a plurality of separation levels; and the substrate manufacturer records identification information formed of information related to the entire substrate and information representing relative relationship about the separation at each of the separation levels on each of information recording portions (8, 9, 10) each of which is provided so as to correspond to each substrate (5, 6, 7) before separation and after separation at each separation level, and delivers the substrate to the mounting manufacturer.

2. The circuit substrate production method according to claim 1, wherein information is recorded as a two-dimensional code on the information recording portions (8, 9, 10).

3. The circuit substrate production method according to claim 1 or 2, wherein, in addition to the identification information of each of the substrates (5, 6, 7) themselves, information related to a production step at the substrate manufacturer and information related to a production step at the mounting manufacturer (2) are recorded on the information recording portions (8, 9, 10) at the substrate manufacturer (1).

4. A circuit substrate production method in which, at a mounting manufacturer (2), a component is mounted on a substrate which is produced by a substrate manufacturer (1) and is delivered to the subsequent mounting manufacturer to thereby produce a circuit substrate, wherein:
a multi-piece substrate (5) is employed which is to be separated into a plurality of pieces at one or each of a plurality of separation levels; at the mounting manufacturer, identification information employed in the mounting manufacturer is recorded on each of information recording portions on the substrate in which, at the substrate manufacturer, identification information formed of information related to the entire substrate and information representing relative relationship about the separation at each of the separation levels has been recorded on each of the information recording portions (8, 9, 10) each of which is provided so as to correspond to each substrate (5, 6, 7) before separation and after separation at each separation level.

5. The circuit substrate production method according to claim 4, wherein, at the mounting manufacturer, mounting is performed on the substrate, which has information about a production step at the mounting manufacturer (2) recorded on the information recording portions (8, 9, 10) at the substrate manufacturer (1) in addition to the identification information about each of the substrates (5, 6, 7) themselves, based on the information which is read from the information recording portions and is related to the production step.

6. The circuit substrate production method according to claim 1, wherein production step information about each of the substrates (5, 6, 7) and the identification information read from the information recording portions (8, 9, 10) are combined in the substrate manufacturer (1) and the mounting manufacturer (2), are transmitted to a data processing center (29) connected via a communication network (28), and are data-processed in the data processing center to thereby construct various databases (30), and wherein the substrate manufacturer and the mounting manufacturer perform required processing by retrieving required data from the databases via the communication network.

7. The circuit substrate production method according to claim 4, wherein production step information about each of the substrates (5, 6, 7) and the identification information read from the information recording portions (8, 9, 10) are combined in the substrate manufacturer (1) and the mounting manufacturer (2), are transmitted to a data processing center (29) connected via a communication network (28), and are data-processed in the data processing center to thereby construct various databases (30), and wherein the substrate manufacturer and the mounting manufacturer perform required processing by retrieving required data from the databases via the communication network.

8. The circuit substrate production method according to claim 6 or 7, wherein the databases (30) contain information about production histories at both the substrate manufacturer (1) and the mounting manufacturer (2).

9. A circuit substrate production system in which a multi-piece substrate (5), which is to be separated into a plurality of pieces at one or each of a plurality of separation levels and has information recording portions (8, 9, 10) each of which is provided so as to correspond to each substrate (5, 6, 7) before separation and after separation at each separation level, is produced at a substrate manufacturer (1), the substrate produced at the substrate manufacturer being delivered to a subsequent mounting manufacturer (2), and in which an electronic component is mounted on the substrate in the mounting manufacturer to thereby produce a circuit substrate, wherein:
in the substrate manufacturer, recording means (17) is provided which records, on each of the information recording portions of the substrate, identification information formed of information related to the entire substrate and information representing relative relationship about the separation at each of the separation levels; and in the mounting manufacturer, read-out means (21, 25) is provided which reads information from the information recording portions.

10. The circuit substrate production system according to claim 9, wherein the recording means (17) in the substrate manufacturer (1) is configured such that, in addition to the identification information of each of the substrates (5, 6, 7) themselves, information about a production step in the substrate manufacturer and information about a production step in the mounting manufacturer (2) are recorded on the information recording portions (8, 9, 10).

11. The circuit substrate production system according to claim 9 or 10, comprising a data processing center (29) which is connected to the substrate manufacturer (1) and the mounting manufacturer (2) via a communication network (28) and processes data transmitted from the substrate manufacturer and the mounting manufacturer to thereby construct various databases (30), wherein read-out means (18, 21, 25) and data processing-transmitting-receiving means (20, 27) are provided in the substrate manufacturer and the mounting manufacturer, the read-out means reading out the identification information recorded on the information recording portions (8, 9, 10) of each of the substrates (5, 6, 7), the data processing-transmitting-receiving means combining production step information about each of the substrates in the substrate manufacturer and the mounting manufacturer and the identification information to transmit to the data processing center and receiving required data from the data processing center.

12. A multi-piece substrate (5) which has one or a plurality of separation levels and is to be separated into a plurality of pieces at each of the separation levels, wherein:
information recording portions (8, 9, 10) are provided, each of which corresponds to each substrate (5, 6, 7) before separation and after separation at each separation level; and identification information formed of information related to the entire substrate and information representing relative relationship about the separation at each of the separation levels is recorded on each of the information recording portions.

13. The multi-piece substrate according to claim 12, wherein production histories at both the substrate manufacturer (1) and the mounting manufacturer (2) are recorded on the information recording portions (8, 9, 10).

14. The multi-piece substrate according to claim 12, wherein, in addition to individual information of the substrates (5, 6, 7) themselves, information required in a production step at the substrate manufacturer (1) and information required in a production step at the mounting manufacturer (2) are recorded on the information recording portions (8, 9, 10).

15. A circuit substrate which is formed by mounting a component on a substrate (6, 7) formed by separating a multi-piece substrate (5) into a plurality of pieces at one or each of a plurality of separation levels, wherein:
the circuit substrate has an information recording portion (8, 9, 10); and identification information formed of information common to all the substrates in the multi-piece substrate and information representing relative relationship between substrates separated at each of the separation levels is recorded on the information recording portion.

16. The circuit substrate according to claim 15, wherein, in addition to the identification information of the substrate (5, 6, 7) itself, information required in a production step at a substrate manufacturer (1) and information required in a production step at a mounting manufacturer (2) are recorded on the information recording portion (8, 9, 10).

17. A circuit substrate production method wherein a combination of production step information and identification information is data-processed in a data processing center (29) to thereby construct various databases (30), the production step information being transmitted from a substrate manufacturer (1) and a mounting manufacturer (2) via a communication network (28) and being related to each of substrates (5, 6, 7) each of which is included in a multi-piece substrate separated into a plurality of pieces at one or each of a plurality of separation levels and serves as a substrate before separation and after separation at each separation level, the identification information being formed of information related to the entire substrate read out from information recording portions (8, 9, 10) provided in each substrate, and information representing relative relationship about the separation at each of the separation levels.

18. The circuit substrate production method according to claim 17, wherein information about production histories at both the substrate manufacturer (1) and the mounting manufacturer (2) is contained in the databases (3a).

19. The circuit substrate production method according to claim 17, wherein information which is retrieved by the substrate manufacturer (1) and the mounting manufacturer (2) via the communication network (28) and is required when required processing is performed is contained in the databases (30).

20. A circuit substrate production method in which a substrate produced by a substrate manufacturer (1) is delivered to a subsequent mounting manufacturer (2) for mounting a component at the mounting manufacturer to thereby produce a circuit substrate, wherein,
when the substrate manufacturer records identification information on an information recording portion provided on the substrate and delivers the substrate to the mounting manufacturer, information related to a production step at the substrate manufacturer and information related to a production step in the mounting manufacturer are recorded, in addition to the identification information of the substrate, on the information recording portion at the substrate manufacturer.

21. A circuit substrate production method in which a substrate produced by a substrate manufacturer (1) is delivered to a subsequent mounting manufacturer (2) for mounting a component at the mounting manufacturer to thereby produce a circuit substrate, wherein:
when the substrate manufacturer records identification information on an information recording portion provided on the substrate and delivers the substrate to the mounting manufacturer, production step information about the substrate and the identification information read out from the information recording portion are combined in the substrate manufacturer and the mounting manufacturer, is transmitted to a data processing center (29) connected via a communication network (28), and is data-processed at the data processing center to thereby construct various databases (30); and the substrate manufacturer and the mounting manufacturer perform required processing by retrieving required data from the databases via the communication network.

22. A circuit substrate, wherein production histories at a substrate manufacturer (1) and a mounting manufacturer (2) are recorded on an information recording portion provided to a substrate in addition to identification information of the substrate.
